# EUROPEAN PATENT APPLICATION

(11) **EP 3 435 543 A1**
(43) Date of publication of application: **30.01.2019**
(21) Application number: 17460046.0
(22) Date of filing: 27.07.2017
(51) Int. Cl.: H03K 17/082, H03K 17/18, H03K 17/14, H03K 17/08

(54) **A SEMICONDUCTOR DEVICE AND METHOD OF MEASUREMENT OF PHYSICAL PARAMETERS OF A SEMICONDUCTOR DEVICE**

(71) Applicant: ABB Schweiz AG, 5400 Baden (CH)
(72) Inventor: Jacukowicz, Rafal, 31-340 Krakow (PL); Kopta, Arnost, CH-8049 Zürich (CH)
(74) Representative: Chochorowska-Winiarska, Krystyna

(57) **Abstract**

A semiconductor device (1) including a power switch packaging (3) and a gate control unit (2) connected together. The power switch packaging (3) includes semiconductor power switch (4) equipped with current terminals (C, E) and a switch control terminal (G). The power switch packaging (3) includes an auxiliary circuit (5) that is equipped with a sensor (6). The sensor (6) is adapted for measuring physical parameters of the semiconductor power switch (4) and for transforming the physical parameters into electrical signal S. The sensor (6) is connected in series with a transmitter circuit (7) for transmitting electrical signal S to the gate control unit (2). The transmitter circuit (7) is connected in series with a power supply circuit (8) adapted for harvesting electrical energy for supplying the auxiliary circuit (5).

## Description

The present invention relates to a semiconductor device including semiconductor power switch and to method of measurement of physical parameters of the semiconductor power switch and transferring measured signal to a control unit of the semiconductor device. The invention is suitable for medium voltage power converters.

Present power converters use power semiconductor devices of which the main power switching element can be realized in different semiconductor technologies and different circuits realizing one-directional or bidirectional current flow. One of most popular circuits is IGBT - Insulated Gate Bipolar Transistor connected antiparallel with a diode. For high voltages special kind of IGBTs are used, adapted to work under blocking voltages over 1,7 kV. The transistor is covered by special case providing high voltage electric insulation between internal and external part of the transistor. The transistor is equipped with at least three terminals: C - collector and E - emitter, both called current terminals and G - gate, called switch control terminal, which is used to control current flow between C and E terminals. The control is realized by suitable voltage between G and E terminals. If voltage between G and E has negative value (-15 to -5V) then current cannot flow from terminal C to E. It is called that transistor is in blocking state and G terminal is in low state. If voltage between G and E has positive value (+5 to +15V) then current can flow from terminal C to E. It is called that transistor is in conducting state and G terminal is in high state. For high voltage transistors, it is essential that suitable distance between all terminals is assured for proper electric insulation.

In the low-voltage (< 1.7kV) semiconductor technology it is common to integrate inside the power modules additional auxiliary circuits e.g. temperature sensors, integrated gate control circuits called gate-drivers, shunts for current sensing, galvanic barriers for separating control signals from high-voltage part, etc. However this is lead out from the module by additional terminals which is related to further design consideration in terms of insulation coordination. This kind of solution is known from US 7,507,023 patent. The patent discloses a power switch packaging equipped with a measurement module, especially the temperature measurement module integrated with the power switch packaging as a one chip. The patent discloses also a method of transferring measured values as an electrical signal from the power switch packaging to a control unit located on the separated chip. The control unit includes a temperature detection circuit and control circuit for controlling a power switch such a power transistor. The transferring of the electrical signal including measured temperature is realized by additional terminals lead out from the power switch packaging and connected to the temperature detection circuit in the control unit.

Auxiliary circuits embedded inside high-voltage semiconductors are not so common mainly due insulation and safety issues which makes additional restrictions for terminals routing in a compact design. Layout and dimensioning of such modules are the industrial standards for the wide variety of products, thus introducing new packaging is costly and limited.

A method of transferring a measuring signal from a power switch packaging to a gate control unit, both included in a semiconductor device, where the power switch packaging includes semiconductor power switch. Semiconductor power switch is equipped with current terminals and a switch control terminal for controlling main current flow between the current terminals by voltage applied between the switch control terminal and one of the specific current terminal. The method includes the following steps:
- Sensing the negative state of the switch control terminal by a transmitter circuit included in an auxiliary circuit, where the auxiliary circuit is connected between one of the specific current output terminal and the switch control terminal.
- Transmitting a specific part of the measuring signal through the switch control terminal by the transmitter circuit if the switch control terminal is in the negative state.
- Stopping the measuring signal transmission through the switch control terminal by the transmitter circuit if the switch control terminal is in the positive state.
- Receiving the specific part of the measuring signal through the switch control terminal by a receiver included in the control unit if the switch control terminal is in the negative state.
- Repeating the above steps until all specific parts of the signal S are transferred.

Preferably, the method includes the first additional step: measuring at least one physical parameter of a semiconductor power switch by a sensor included in the auxiliary circuit and converting the physical parameter into electrical signal as the specific part of the measuring signal.

Preferably, the measuring signal has a form of an analog signal.

Preferably, the specific part of the measuring signal has a form of immediate current value.

Alternatively, the measuring signal has a form of a digital signal.

Preferably, the specific part of the measuring signal has a form of one bit.

A semiconductor device including a power switch packaging and a gate control unit connected together. The power switch packaging includes semiconductor power switch equipped with current terminals and a switch control terminal for controlling main current flow between the current terminals by voltage applied between the switch control terminal and one of the specific current terminal. The semiconductor device is characterized in that, the power switch packaging includes an auxiliary circuit that is equipped with a sensor. The sensor is adapted for measuring physical parameters of the semiconductor power switch and for transforming the physical parameters into electrical signal. The sensor is connected in series with a transmitter circuit for transmitting electrical signal to the gate control unit. The transmitter circuit is connected in series with a power supply circuit.

Preferably, the power switch packaging is connected with the gate control unit by the current terminal and the switch control terminal.

Preferably, the semiconductor power switch contains at least one Insulated Gate Bipolar Transistor.

Preferably, the power supply circuit is adapted for harvesting electrical energy for supplying the auxiliary circuit.

A power switch packaging including a semiconductor power switch equipped with current terminals and a switch control terminal for controlling main current flow between the current terminals by voltage applied between the switch control terminal and one of the specific current terminal. The power switch packaging is characterized in that, an auxiliary circuit is connected between one of the specific current terminal and the switch control terminal. The auxiliary circuit is adapted for measuring physical parameters of the semiconductor power switch.

Preferably, the auxiliary circuit comprises a sensor for measuring physical parameter of the semiconductor power switch and for transforming the physical parameter into electrical signal. The sensor is connected in series with a transmitter circuit for transmitting electrical signal. The transmitter circuit is connected in series with a power supply circuit adapted for harvesting electrical energy for supplying the auxiliary circuit.

Preferably, the semiconductor power switch, the sensor, the transmitter circuit and the power supply circuit are integrated in one solid chip.

Preferably, the sensor is at least a temperature sensor, a humidity sensor, a tension sensor, a magnetic field sensor or their combinations.

Preferably, the semiconductor power switch contains Insulated Gate Bipolar Transistor.

The main advantage of the invention is that the measuring signal, which is an electrical signal reflecting values of measured physical parameter of the semiconductor power switch, is transferred from the power switch packaging to the gate control unit by use of original terminals of the semiconductor power switch. It means that no additional terminal is needed, thus no modification of layout or dimension of power switch packaging is required. It allows for keeping restricted industrial standards related to insulation of high-voltage power elements. The method of transferring the measuring signal is useful for both analogue and digital signal and can relate to measurements of any physical parameters inside the semiconductor power switch like temperature, magnetic field, humidity etc. Moreover, the invention allows for using energy harvesting inside the power switch packaging, thus no additional power supply is needed for whichever sensor and transmitter circuit included in the power switch packaging.

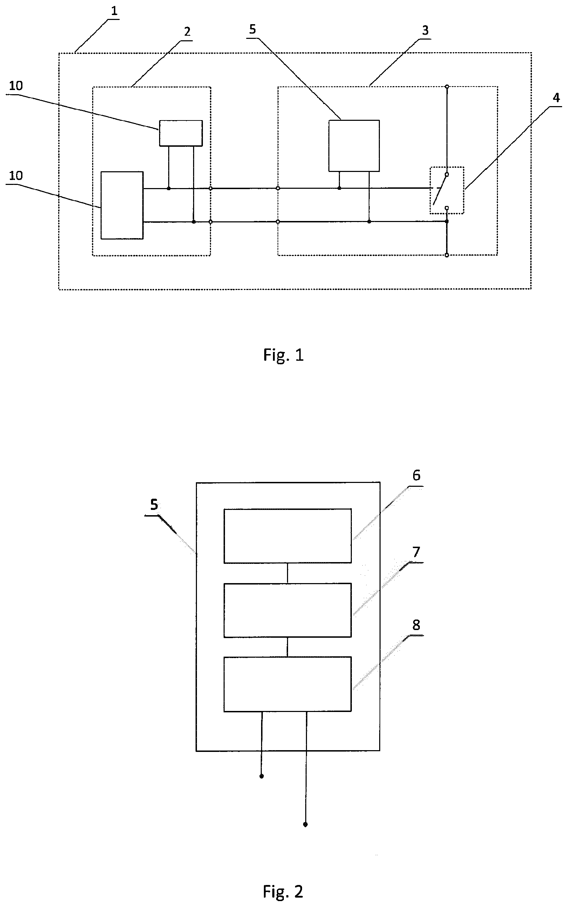

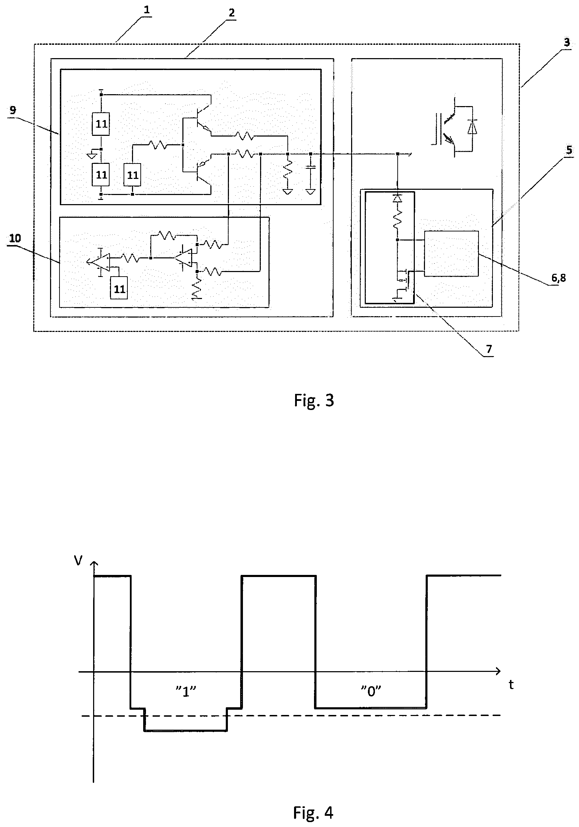

The method and the device according to the invention are explained with an example of their embodiment in the drawing where fig. 1 shows a schematic diagram of a semiconductor device, fig. 2 shows detailed structure of an auxiliary circuit, fig. 3 shows detailed implementation of the first embodiment of the invention and fig. 4 shows diagram of data transfer.

In all embodiments of the invention, a semiconductor device 1 includes a power switch packaging 3 and a gate control unit 2 connected together. The power switch packaging 3 contains a semiconductor power switch 4, which is placed inside high voltage electric insulation case forming power switch packaging 3. A current terminal C, a current terminal E and a switch control terminal G of the semiconductor power switch 4 are led out of the power switch packaging 3 at such intervals to ensure proper electric insulation between terminals. The terminals C, E and G are the only terminals of the power switch packaging 3.

In the first embodiment of the invention, the semiconductor power switch 4 is made as a circuit including IGBT connected with antiparallel diode. Additionally, power switch packaging 3 is internally equipped with extra low-power auxiliary circuit 5, equipped with a sensor 6, a transmitter circuit 7 and low power supply circuit 8. The functionality of the auxiliary circuit 5 has no influence on primary switching operation of the semiconductor power switch 4. The auxiliary circuit 5 is electrically connected to the terminals E and G of the semiconductor power switch 4. The power supply circuit 8 supplies the sensor 6 and the transmitter circuit 7 from voltage applied between G and E terminals. The power supply circuit 8 takes energy from the gate control unit 2 in a manner not influencing primary characteristic of the semiconductor power switch 4. In other words, the power supply circuit 8 is adapted for energy harvesting e.g. from the gate control unit 2. The sensor 6 is providing signal S which is corresponding to a physical value measured by the sensor 6 and is proceed by the transmitter circuit 7. The transmitter circuit 7 converts signal S into binary value.

The gate control unit 2 is equipped with a gate driver 9 and a receiver circuit 10 which is electrically connected with the gate driver 9. The role of the gate driver 9 is to trip on and off the semiconductor power switch 4. The role of the receiver circuit 10 is to receive signal S from the sensor 6 of the power switch packaging 3. Both the gate driver 9 and the receiver circuit 10 are equipped with internal supplies 11.

In the power switch packaging, the transmitter circuit 7 is synchronized with voltage between G and E terminals in the way that it detects negative, positive and polarity change of the voltage. The transmitter circuit 7 transmits only one bit per positive to negative transition of the G E voltage. When the transmitter circuit 7 transmits binary "1", it must wait for the transition and increase gate terminal current consumption during negative state of the voltage. When the transmitter circuit 7 transmits binary "0" it not influencing low state of the voltage.

In the gate control unit 2, the receiver circuit 10 is synchronized with the gate driver 9 in way that it detects low, high and change state of the gate driver 9 output connected to G and E terminals. The receiver circuit 10 receives only one bit per falling edge of the gate driver output. When the receiver circuit 10 detects the falling edge, it monitors condition of a low state of the gate driver 9 output. If the condition of the low state has characteristic parameters in explicit increased current consumption, the receiver circuit 10 assigns logic "1" to this condition. If the condition of the low state has no characteristic patterns, the receiver circuit 10 assigns logic "0".

Transfer of the whole signal S from the sensor 6 to the receiver circuit 10 is realized as the transfer of a single specific parts of the signal S in successive cycles of the semiconductor power switch 4 tripping generated by the gate driver 9. It is done in the following steps:
- sensing the negative state of the control terminal G by a transmitter circuit 7;
- if the control terminal G is in the negative state then transmitting the specific part of the measuring signal S through the control terminal G by the transmitter circuit 7;
- if the control terminal G is in the positive state then stopping the measuring signal S transmission through the control terminal G by the transmitter circuit 7;
- receiving the specific part of the measuring signal S through the control terminal G by a receiver circuit 10 included in the control unit 2.

The above steps are repeated until all parts of the signal S are transferred to the receiver circuit 10 in the control module 2. In the first embodiment of the invention, the signal S is in the form of digital signal and the specific part of the signal S is one bit. Thus, one bit of data stored in the signal S is transferred during one tripping cycle of the gate driver 9.

In the second embodiments of the invention, not shown on drawing, the auxiliary circuit 5 is supplied from collector circuit and it is realized by connecting of the auxiliary circuit 5 to all three terminals: G, E and C. In this embodiment the source of the semiconductor power switch 4 is loaded, instead of the gate driver 9 loading.

In the third embodiments of the invention, not shown on drawing, the semiconductor power switch 4 contains single power transistor, or it contains a circuit comprising two power transistors connected antiparallel, or it contains a thyristor or a triac.

In the fourth embodiments of the invention, not shown on drawing, the measuring signal S can be transferred as an analog signal. In that case, the specific part of the signal S transferred in one tripping cycle is the form of an instantaneous current value. If the measuring signal S has digital form, then the specific part of the signal S is defined as one or more bits.

The invention is applicable especially in medium voltage drives and power converters but is also useful in HVDC applications, as well as in transportation like wayside fixed installations or rolling stocks. Especially, the invention can be used in HiPAK^{™} IGBT modules for traction.

## Claims

1. Method of transferring a measuring signal (S) from a power switch packaging (3) to a gate control unit (2), both included in a semiconductor device (1), where the power switch packaging (3) includes semiconductor power switch (4) equipped with current terminals (C, E) and a switch control terminal (G) for controlling main current flow between the current terminals (C, E) by voltage applied between the switch control terminal (G) and one of the specific current terminal (C, E),
wherein the method includes the following steps:
- sensing the negative state of the switch control terminal (G) by a transmitter circuit (7) included in an auxiliary circuit (5), where the auxiliary circuit (5) is connected between one of the specific current output terminal (C, E) and the switch control terminal (G);
- transmitting a specific part of the measuring signal (S) through the switch control terminal (G) by the transmitter circuit (7) if the switch control terminal (G) is in the negative state;
- stopping the measuring signal (S) transmission through the switch control terminal (G) by the transmitter circuit (7) if the switch control terminal (G) is in the positive state;
- receiving the specific part of the measuring signal (S) through the switch control terminal (G) by a receiver (10) included in the control unit (2) if the switch control terminal (G) is in the negative state;
- repeating the above steps until all specific parts of the signal (S) are transferred.

2. Method according to claim 1, including the first step:
- measuring at least one physical parameter of a semiconductor power switch (4) by a sensor (6) included in the auxiliary circuit (5) and converting the physical parameter into electrical signal as the specific part of the measuring signal (S).

3. Method according to claim 1 or 2, **characterized in that** that the measuring signal (S) has a form of an analog signal.

4. Method according to claim 3, **characterized in that**, the specific part of the measuring signal (S) has a form of immediate current value.

5. Method according to claim 1 or 2, **characterized in that**, the measuring signal (S) has a form of a digital signal.

6. Method according to claim 5, **characterized in that**, the specific part of the measuring signal (S) has a form of one bit.

7. A semiconductor device (1) including a power switch packaging (3) and a gate control unit (2) connected together, wherein the power switch packaging (3) includes semiconductor power switch (4) equipped with current terminals (C, E) and a switch control terminal (G) for controlling main current flow between the current terminals (C, E) by voltage applied between the switch control terminal (G) and one of the specific current terminal (C, E), **characterized in that,** the power switch packaging (3) includes an auxiliary circuit (5) that is equipped with a sensor (6), said sensor (6) is adapted for measuring physical parameters of the semiconductor power switch (4) and for transforming the physical parameters into electrical signal S; said sensor (6) is connected in series with a transmitter circuit (7) for transmitting electrical signal S to the gate control unit (2); said transmitter circuit (7) is connected in series with a power supply circuit (8).

8. A semiconductor device according to claim 7, **characterized in that**, the power switch packaging (3) is connected with the gate control unit (2) by the current terminal (E) and the switch control terminal (G).

9. A semiconductor device according to claim 7 or 8, **characterized in that**, the semiconductor power switch (4) contains at least one Insulated Gate Bipolar Transistor.

10. A semiconductor device according to any of the claims 7 to 9, **characterized in that**, the power supply circuit (8) is adapted for harvesting electrical energy for supplying the auxiliary circuit (5).

11. A power switch packaging (3) including a semiconductor power switch (4) equipped with current terminals (C, E) and a switch control terminal (G) for controlling main current flow between the current terminals (C, E) by voltage applied between the switch control terminal (G) and one of the specific current terminal (C, E), **characterized in that,** an auxiliary circuit (5) is connected between one of the specific current terminal (C, E) and the switch control terminal (G), said auxiliary circuit (5) is adapted for measuring physical parameters of the semiconductor power switch (4).

12. A power switch packaging according to claim 11, **characterized in that**, the auxiliary circuit (5) comprises a sensor (6) for measuring physical parameter of the semiconductor power switch (4) and for transforming the physical parameter into electrical signal (S); said sensor (6) is connected in series with a transmitter circuit (7) for transmitting electrical signal (S); said transmitter circuit (7) is connected in series with a power supply circuit (8) adapted for harvesting electrical energy for supplying the auxiliary circuit (5).

13. A power switch packaging according to claim 11, **characterized in that**, the semiconductor power switch (4), the sensor (6), the transmitter circuit (7) and the power supply circuit (8) are integrated in one solid chip.

14. A power switch packaging according to claim 12, **characterized in that**, the sensor (6) is at least a temperature sensor, a humidity sensor, a tension sensor, a magnetic field sensor or their combinations.

15. A power switch packaging according to any of the claims 11 to 14, **characterized in that**, the semiconductor power switch (4) contains Insulated Gate Bipolar Transistor.
